(19) Europäisches Patentamt European Patent Office Office européen des brevets

(11) **EP 1 959 502 A1**

(12) **DEMANDE DE BREVET EUROPEEN**

(43) Date de publication:
   **20.08.2008 Bulletin 2008/34**

(51) Int Cl.:
   ***H01L 31/048*** *(2006.01)*

(21) Numéro de dépôt: **07290184.6**

(22) Date de dépôt: **14.02.2007**

(84) Etats contractants désignés:
   **AT BE BG CH CY CZ DE DK EE ES FI FR GB GR HU IE IS IT LI LT LU LV MC NL PL PT RO SE SI SK TR**
   Etats d'extension désignés:
   **AL BA HR MK RS**

(71) Demandeurs:
   • **Imphy Alloys**
    **93200 Saint Denis (FR)**
   • **Apollon Solar s.a.s.**
    **69002 Lyon (FR)**

(72) Inventeurs:
   • **Reyal, Jean-Pierre**
    **95610 Eragny (FR)**
   • **Giusti, Jérôme**
    **58000 Nevers (FR)**
   • **Bamberg, Klaus**
    **69003 Lyon (FR)**

(74) Mandataire: **Plaisant, Sophie Marie et al**
   **ARCELOR France**
   **Arcelor Research Intellectual Property**
   **5 Rue Luigi Cherubini**
   **93212 La Plaine Saint-Denis Cedex (FR)**

(54) **Module photovoltaïque et modules de production d'énergie ou de lumière**

(57) L'invention concerne un module (1) de production de lumière ou d'énergie comprenant au moins un générateur de lumière ou d'énergie incluant au moins une cellule en semi-conducteur (2) et disposé dans une enceinte étanche sous pression réduite, l'enceinte comprenant une face avant (3) en verre, une face arrière (4) en métal ou alliage métallique éventuellement revêtue sur l'une ou l'autre de ses faces, un joint de scellement périphérique (5), ainsi que des connecteurs électriques (6), la face arrière (4) étant isolée électriquement des générateurs, et la face arrière (4) présentant une épaisseur de métal ou d'alliage métallique inférieure à 1 mm Elle concerne plus particulièrement les modules photovoltaïques, les modules d'éclairage LED ou OLED.

**Fig. 2**

**Description**

La présente invention concerne un module de production d'énergie ou de lumière, plus particulièrement destiné à la fabrication de modules photovoltaïques pour la production d'électricité à partir du rayonnement solaire, sans pour autant y être limitée.

Les modules photovoltaïques au silicium sont généralement constitués d'assemblages de cellules en silicium, monocristallin ou poly-cristallin, qui sont généralement connectées en série ou en parallèle, puis placées entre une face avant transparente et une face arrière, avec interposition de différentes couches de polymères et/ou de colles.

La face avant transparente est généralement en verre, dirigée vers le soleil, et a pour rôle de laisser passer le rayonnement solaire, mais aussi de protéger la cellule des impacts divers. La face arrière peut être constituée de différents matériaux. On utilisera du verre lorsque le module doit être transparent, mais on utilisera de préférence un empilement de polymères lorsqu'il peut être opaque, ce qui permet alors de protéger les cellules des agressions mécaniques.

Les cellules sont connectées entre elles à l'aide de bandes de cuivre, les cellules dites « à contact avant » étant reliées de face avant d'une cellule à la face arrière de la cellule adjacente, tandis que les cellules dites « à contact arrière » sont reliées de face arrière de cellule à la face arrière de la cellule adjacente.

On connaît deux technologies de fabrication de ces modules qui sont l'encapsulation à chaud et le scellement à froid. L'encapsulation à chaud consiste à empiler les couches successives du module, à savoir au moins une face avant en verre, une couche de polymère transparent, les cellules connectées entre elles, un composite commercialisé sous le nom de Tedlar®, une face arrière enduite de colle thermo-activable, et à les presser à chaud. En fonction des besoins, on peut ajouter avant pressage différentes couches de renfort en fibres de verre, des couches de polymère permettant notamment d'absorber les rayonnements infrarouge et ultraviolet et de restituer un rayonnement dans le domaine du visible, par exemple.

Cette technologie présente certains inconvénients, car les différentes couches de l'empilage ont tendance à se déplacer les unes par rapport aux autres lors du pressage. En particulier, les forces générées sont suffisantes pour faire que les cellules silicium et les contacts de cuivre se déplacent les uns par rapport aux autres, entraînant un mauvais rendement électrique.

Le scellement à froid consiste, quant à lui, à empiler les couches successives constitutives du module, puis à disposer un joint de scellement périphérique autour du module pour réaliser une enceinte étanche. Cette enceinte est ensuite balayée d'un gaz neutre, puis mise en dépression par aspiration, ce qui vient sceller le module en comprimant le joint périphérique. On se référera en particulier à la demande de brevet WO 2004/095586 pour une description détaillée de ce procédé de fabrication.

Ce document préconise notamment l'utilisation d'une face arrière rigide, pouvant être réalisée en verre de forte épaisseur allant de 2 à 4 mm ou par une feuille rigide en métal traité en surface. Or, les hétérogénéités de planéité de telles faces induisent nécessairement une dispersion des surfaces et des forces de contact des connecteurs sur les cellules au silicium. Cette dispersion des courbures peut parfois même aller jusqu'à la rupture des cellules et n'est dans tous les cas pas favorable à un bon rendement électrique.

Le but de la présente invention est donc de remédier aux inconvénients des modules de l'art antérieur en mettant à disposition un module de production d'énergie ou de lumière présentant un rendement énergétique amélioré durablement et une durée de vie d'au moins 30 ans, ce qui implique notamment un maintien du vide dans l'enceinte du module, une protection des cellules contre les agressions mécaniques, une résistance à la corrosion améliorée et un maintien de l'étanchéité à la vapeur d'eau pendant cette même durée.

A cet effet, un premier objet de la présente invention est constitué par un module de production de lumière ou d'énergie comprenant au moins un générateur de lumière ou d'énergie incluant au moins une cellule en semi-conducteur et disposé dans une enceinte étanche sous pression réduite, ladite enceinte comprenant une face avant en verre, une face arrière en métal ou alliage métallique éventuellement revêtue sur l'une ou l'autre de ses faces, un joint de scellement périphérique, ainsi que des connecteurs électriques, ladite face arrière étant isolée électriquement desdits générateurs, caractérisé en ce que ladite face arrière présente une épaisseur de métal ou d'alliage métallique inférieure à 1 mm.

Le module selon l'invention peut également comprendre différentes caractéristiques, prises seules ou en combinaison :

-    la face arrière présente une épaisseur de métal ou d'alliage métallique inférieure ou égale à 0,3 mm et en ce que la face arrière présente un coefficient de dilatation $\alpha_{FA}$ entre 0 et 100°C dont la différence en valeur absolue par rapport au coefficient de dilatation $\alpha_{SC}$ du semi-conducteur entre 0 et 100°C est telle que :

$$\left| \alpha_{FA} - \alpha_{SC} \right| \leq 5.10^{-6} \text{ K}^{-1}$$

- la face arrière présente un coefficient de dilatation $\alpha_{FA}$ entre 0 et 100°C dont la différence en valeur absolue par rapport au coefficient de dilatation $\alpha_{SC}$ dudit semi-conducteur entre 0 et 100°C est telle que :

$$\left|\alpha_{FA} - \alpha_{SC}\right| > 5.10^{-6} \text{K}^{-1}$$

la face arrière présentant une épaisseur de métal ou d'alliage métallique inférieure ou égale à 0,3 mm et étant mise en forme dans les zones situées entre les cellules en semi-conducteur, de telle sorte qu'elle ne vienne pas en contact avec les bords de ces cellules lors du fonctionnement du module.

- la face arrière présente une épaisseur de métal ou d'alliage métallique supérieure à 0,3 mm et en ce que la face arrière présente un coefficient de dilatation $\alpha_{FA}$ entre 0 et 100°C, dont la différence en valeur absolue par rapport au coefficient de dilatation $\alpha_{SC}$ du semi-conducteur est telle que :

$$\left|\alpha_{FA} - \alpha_{SC}\right| \leq 4,5.10^{-6} \text{ K}^{-1}$$

- la face arrière est isolée des dites cellules à l'aide d'un revêtement isolant choisi parmi les polymères non-conducteurs,
- le revêtement comprend des composés isolants électriques et conducteurs thermiques, susceptibles d'extraire la chaleur du module, tels que des poudres de nitrures d'aluminium.

Dans un mode de réalisation préféré, le module selon l'invention est un module photovoltaïque, qui peut comprendre de façon plus particulièrement préférée l'une quelconque des caractéristiques suivantes, seules ou en combinaison :

- le semi-conducteur est le silicium, la face arrière présente une épaisseur inférieure ou égale à 0,3 mm et est constituée d'alliage fer-Nickel comprenant 34 à 42% de nickel, avec ou sans revêtement de protection contre la corrosion,
- le semi-conducteur est le silicium, la face arrière présente une épaisseur inférieure ou égale à 0,3 mm, est constituée d'acier inoxydable de type F18MT et est mise en forme dans les zones entre les cellules de semi-conducteur, de telle sorte que la face arrière n'entre pas en contact avec les bords de ces cellules,
- la face arrière présente une épaisseur supérieure à 0,3 mm, est constituée d'alliage fer-Nickel de type N485 ou d'acier inoxydable de type F18MT et est mise en forme dans les zones entre les cellules de semi-conducteur, de telle sorte que la face arrière n'entre pas en contact avec les bords de ces cellules,
- la face arrière présente une épaisseur supérieure à 0,3 mm, est constituée d'acier au carbone galvanisé et est mise en forme dans les zones entre les cellules de semi-conducteur, de telle sorte que la face arrière n'entre pas en contact avec les bords de ces cellules.

Dans d'autres modes de réalisation préférés, le module selon l'invention peut prendre la forme d'un écran de visualisation, ou d'un module d'éclairage LED ou OLED.

Les termes N485, F18MT, N426, N475, F17T et 316L se rapportent aux normes qui définissent les gammes de compositions des aciers et alliages concernés (NF EN 10088-2 pour les aciers inoxydables et ISO 6372 pour les alliages fer-nickel).

Les présents inventeurs ont en effet constaté que lorsque l'on utilise une face arrière en métal ou alliage métallique d'une épaisseur inférieure à 1 mm et de préférence inférieure à 0,6 mm, c'est à dire non-rigide, il était alors possible d'adapter le comportement mécanique de cette face arrière à celui du reste du module, et donc de limiter les dégradations des modules au fur et à mesures des cycles thermiques, mais surtout d'améliorer durablement le rendement énergétique des générateurs.

En particulier, ils ont constaté qu'en dessous d'une épaisseur de 0,3 mm, il était particulièrement avantageux d'adapter la dilatation de la face arrière à la dilatation des cellules des générateurs insérés dans les modules. En effet, pour de telles épaisseurs, on observe qu'après mise sous vide, les feuilles métalliques épousent la forme de ces générateurs et le risque principal de détérioration vient alors d'une différence de dilatation entre ces deux éléments dès le début du fonctionnement du module.

Lorsqu'il n'est pas possible ou pas souhaitable de choisir un matériau à coefficient de dilatation adapté à celui des cellules des générateurs, il est alors possible de préserver l'intégrité de ces cellules par une mise en forme de la face arrière, au niveau des zones entre les cellules. Cette mise en forme est exécutée de telle sorte que la face arrière ne vienne jamais en contact avec les bords des cellules, pendant le fonctionnement de celui-ci.

Les présents inventeurs ont en outre constaté que pour des épaisseurs comprises entre 0,3 mm et 1 mm, et de préférence entre 0,3 mm et 0,6 mm, il était également avantageux d'adapter la dilatation de la face arrière à la dilatation du silicium. En effet, pour ces épaisseurs plus fortes, la feuille métallique se déforme moins et nappe moins les générateurs, mais le risque principal de dégradation vient d'une rupture en fatigue des cellules due à la contrainte cyclique qu'elles vont subir lors du fonctionnement du module.

Les épaisseurs dont il est question sont celles des feuilles en métal ou en alliage métallique, sans prendre en compte les éventuelles épaisseurs de revêtements.

Dans des modes de réalisation préférés, le module selon l'invention peut constituer un module photovoltaïque, tel qu'un module à cellules en silicium, ou bien encore un écran de visualisation de type OLED (« Organic Light-Emitting Diode », encore appelée diode organique électro-luminescente), ou un module d'éclairage LED (« Light Emitting Diode » encore appelée diode électroluminescente) ou OLED.

La description qui suit se référera à un module photovoltaïque comportant des cellules en silicium, mais il est bien entendu que l'invention ne s'y limite pas et englobe, notamment, l'ensemble des modules photovoltaïques ainsi que l'ensemble des écrans de visualisations et l'ensemble des modules d'éclairage de type LED ou OLED.

Pour ce qui concerne les modules photovoltaïques, on pourra ainsi utiliser de façon avantageuse des cellules en silicium, mono ou poly-cristallin, ou en arséniure de gallium, ou tout autre semi-conducteur adapté.

Les caractéristiques et avantages de l'invention apparaîtront à la lecture de la description qui va suivre, donnée uniquement à titre d'exemple, en référence aux schémas annexés qui représentent :

- figure 1 : une vue de dessus d'un premier module photovoltaïque de 16 cellules au silicium selon l'invention,
- figure 2 : une vue en coupe d'un deuxième module à 4 cellules selon l'invention, munie d'une face arrière mince,
- figure 3 : une vue en coupe d'un troisième module à 4 cellules au silicium selon l'invention, à face arrière mise en forme, avant sa mise sous vide,
- figure 4 : une vue en coupe du module de la figure 3, après sa mise sous vide,
- figure 5 : figure 2 : une vue en coupe d'un quatrième module à 4 cellules selon l'invention, munie d'une face arrière épaisse.

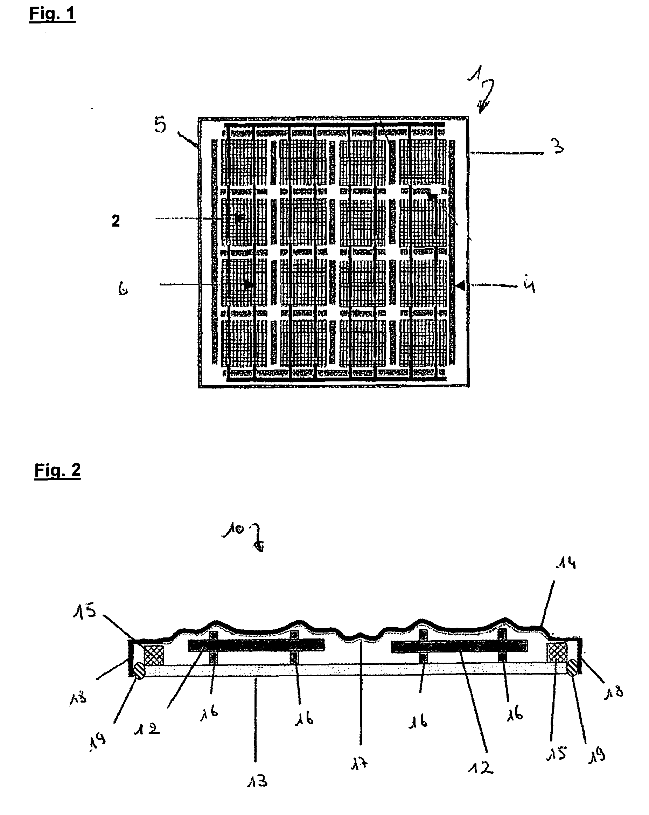

La figure 1 représente schématiquement, en vue de dessus, un module photovoltaïque 1 à contact avant, composé de 16 cellules 2 en semi-conducteur. Les cellules 2 sont disposées de façon matricielle entre une face avant 3 en verre et une face arrière 4 en métal selon l'invention. Un joint de scellement 5 en polyoléfine, tel que, par exemple un poly-butylène, est placé sur toute la périphérie du module 1.

On utilisera de préférence une face avant en verre à haute transmission ayant une bonne résistance mécanique (verre sodo-calcique), dont le coefficient de dilatation entre 0 et 100°C est proche de $10.10^{-6}$ K$^{-1}$. La face avant présente généralement une épaisseur inférieure à 6 mm, une valeur typique étant de 3 à 4 mm.

Les cellules 2 sont reliées entre elles par contact avec un réseau de connecteurs en cuivre 6 qui sont en contact avec la face avant 3 et la face arrière 4 du module 1.

Lors de la fabrication du module, le volume intérieur étanche du module est rempli d'argon. Une dépression a ensuite été formée par aspiration afin d'assurer une pression de contact suffisante pour permettre la conduction électrique sans soudure des contacts de connexion en cuivre 6 des cellules 2. Ces contacts 6 peuvent glisser sur la face avant 3 en verre, mais ne glissent pas contre la face arrière 4 qui présente une rugosité trop importante pour cela. On comprend donc que tout déplacement de la face arrière 4, par dilatation sous l'effet de la chaleur par exemple, peut endommager les cellules 2.

Dans le cadre de la présente invention, on entend par pression réduite une pression comprise entre 100 et 700 mbar, et de préférence voisine de 500 mbar.

Outre une face avant, une face arrière et des cellules de semiconducteurs, les modules selon l'invention pourront comprendre différentes couches de matière, sous forme de revêtements ou sous forme de couche indépendante, en fonction des matériaux et des épaisseurs requises.

En fonction des besoins, on pourra ainsi ajouter des matières de renfort, des matières permettant notamment d'absorber les rayonnements infrarouge et ultraviolet et de restituer un rayonnement dans le domaine du visible, par exemple.

Les feuilles métalliques qui ne sont pas naturellement inoxydables pourront être revêtues d'une couche protectrice sur leurs faces externes.

En effet, les parties métalliques des modules photovoltaïques doivent résister pendant 30 ans à la corrosion atmosphérique pour conserver la dépression indispensable aux contacts électriques. Ils doivent en particulier résister à :

- la corrosion par piqûre,
- la corrosion sous contrainte,

- la corrosion galvanique.

Tout type de dépôt est envisageable et en particulier ceux utilisés dans l'industrie du bâtiment, du transport terrestre et maritime, ou des tubes, tels que le dépôt électrolytique ou PE-CVD (Plasma-Enhanced Chemical Vapor Deposition) de nickel ou d'autres métaux, l'étamage au trempé à chaud, un dépôt électrolytique de Zn, l'enduction de peinture, la protection par cataphorèse, etc.

Par ailleurs, les faces internes des faces arrière selon l'invention doivent être isolées électriquement par rapport aux générateurs des modules. On pourra utiliser à cet effet tout revêtement isolant adapté, comme un revêtement de polymère, une couche mince d'oxyde ou une couche épaisse d'isolant déposée par sérigraphie. La face arrière peut également être isolée grâce à la colle éventuellement présente pour l'assemblage du module.

On préfère en particulier utiliser un revêtement comprenant des particules permettant d'extraire en continu la chaleur du module, comme par exemple les nitrures d'aluminium, notamment sous forme de poudre.

Dans un mode de réalisation particulier, on pourra recouvrir la face interne de la face arrière d'une succession de revêtements dont les coefficients de dilatation entre 0 et 100°C formeront un gradient, afin de compenser partiellement un écart de dilatation entre la face arrière et les cellules en semi-conducteur. Une telle disposition pourra permettre une adaptation de $1.10^{-6}$ K$^{-1}$ au maximum.

Dans un premier mode de réalisation, on préfère utiliser une face arrière de module présentant une épaisseur inférieure ou égale à 0,3 mm. Comme cela a déjà été indiqué auparavant, les présents inventeurs ont constaté qu'en dessous d'une épaisseur de 0,3 mm, il était particulièrement avantageux d'adapter la dilatation de la face arrière à la dilatation des générateurs insérés dans les modules, car on observe alors que les feuilles métalliques épousent la forme de ces générateurs.

Ainsi, dans le cas d'un module photovoltaïque au silicium, une feuille mince dont le coefficient moyen de dilatation entre -50°C et +100°C est proche de celui du silicium (environ $4.10^{-6}$ K$^{-1}$) permet à la fois d'améliorer la performance électrique des modules et d'éviter la fissuration des cellules photovoltaïques.

La figure 2 représente schématiquement un module 10 à 4 cellules au silicium 12 présentant une face arrière 14 de 0,2 mm en Invar®. Le module 10 présente également une face avant en verre sodo-calcique 13 ainsi qu'un joint périphérique 15 en poly-butylène. Les cellules 12 sont reliées à des connecteurs en cuivre 16 qui glissent sur la face avant 13 en verre.

La face arrière 14 est enduite sur sa face interne d'une couche de colle 17. La face arrière 14 vient napper les cellules 12 et est repliée sur ses bords 18. Pour assurer l'étanchéité du module 10, un joint silicone 19 est formé entre les bords 18 et la face avant 13.

On observe en particulier les améliorations suivantes :

- le feuillard nappe les cellules photovoltaïques sous l'effet de la dépression,
- la pression sur les contacts électriques est élevée et uniformément répartie,
- l'écart de dilatation (feuille métallique/Silicium) est trop faible pour cisailler et fissurer les extrémités des cellules.

La dilatation du silicium étant généralement comprise entre $2,5.10^{-6}$ K$^{-1}$ et $4,5.10^{-6}$ K$^{-1}$, il est préférable que l'écart de dilatation entre la face arrière mince et les cellules photovoltaïques de silicium n'excède pas $5.10^{-6}$ K$^{-1}$. De ce fait, la dilatation des faces arrière minces pour une telle cellule au silicium doit généralement être comprise entre 0 et $9,5.10^{-6}$ K$^{-1}$.

Exemple 1 - Tenue du module à face arrière non mise en forme

On a réalisé une série de modules photovoltaïques comprenant une face avant en verre et une face arrière métallique mince en différents matériaux, le module étant scellé par un joint organique périphérique et par un joint silicone. Les modules réalisés comprennent des cellules au silicium, dont le coefficient de dilatation entre 0 et 100°C est de $\alpha_{SC} = 4,5.10^{-6}$ K$^{-1}$.

Les faces avant sont des plaques en verre sodo-calcique d'une épaisseur de 3 mm.

Les faces arrières n'ont pas été mises en forme et sont donc planes, avant mise sous vide, à l'exception de leurs bords qui sont repliés comme représentés en figure 2.

Ces modules ont été soumis à un test d'évolution des cellules photovoltaïques en silicium, après une série de 200 cycles entre -45°C et +85°C.

Les résultats de ces essais sont rassemblés dans le tableau 1:

Tableau 1

| Essai . | Face arrière | Epaisseur (mm) | Composition (% poids) | $\alpha_{FA}$ ($10^{-6}$ °K$^{-1}$) | $|\alpha_{FA} - \alpha_{SC}|$ | Etat des cellules Si |
|---|---|---|---|---|---|---|
| 1* | Invar® | 0,1 | 36Ni-Fe | 1,1 | 3,4 | bon |
| 2* | N42 | 0,1 | 42Ni-Fe | 3,8 | 0,7 | bon |
| 3* | Dilver P ® | 0,1 | 29Ni-18Co-Fe | 6,2 | 1,7 | bon |
| 4 | N485 | 0,15 | 48Ni-6Cr-Fe | 9,2 | 4,7 | Bon |
| 5 | Inox 316L | 0,15 | 17,5Cr-12,5Ni-2,5Mo-Fe | 16 | 11,5 | Fissures |
| * : selon l'invention | | | | | | |

On constate le bon comportement des modules selon l'invention qui, seuls permettent d'obtenir un état satisfaisant des cellules au silicium.

Exemple 2 - Rendement électrique

Par ailleurs, on a réalisé des essais électriques avec un premier module à 6 cellules au silicium présentant une face arrière en Invar® de 0,22 mm. La face arrière métallique est plane avant mise sous vide, à l'exception de ses bords, et ne comporte pas de revêtements modifiant le coefficient de dilatation de la face arrière.

Essai 1 - Damp heat test

Ces essais ont consistés à déterminer l'évolution du facteur de forme FF du module pendant plus de 3000 heures à une température de 85°C sous 85% d'humidité selon la norme IEC 61215 (damp heat test). Les résultats sont rassemblés dans le tableau 2 :

Tableau 2

| | 6 cellules verre-Invar® |
|---|---|
| Heures | % FF |
| 0 | 77 |
| 500 | 76,8 |
| 1000 | 77 |
| 1500 | 77 |
| 2000 | 76 |
| 3000 | 77 |

On constate que l'utilisation d'une face arrière en Invar® permet une grande stabilité du rendement électrique du module au cours du temps.

Essai 2 - Thermo-cycle test

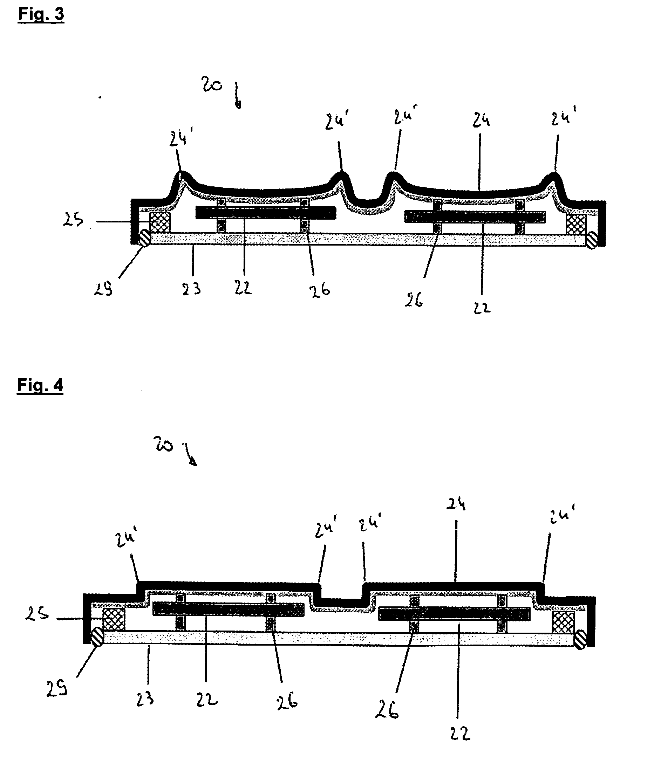

On a ensuite poursuivi les tests avec un module à 12 cellules au silicium, présentant une face arrière plane en Invar® de 0,22 mm.
Les essais visaient à déterminer l'évolution du facteur de forme FF du module, au cours d'une succession de 200 cycles thermiques de 6 heures entre -40°C et +85°C, selon la norme IEC 61215 (thermo-cycle test).
On mesure que les valeurs du facteur de forme du module selon l'invention ont une amplitude de variation de 0,3%.
On constate que le facteur de forme du module selon l'invention apparaît beaucoup plus stable dans le temps que celui d'un module de l'art antérieur.
Dans un deuxième mode de réalisation, on préfère utiliser une face arrière dont le coefficient de dilatation entre 0 et 100°C est éloigné de celui du semi-conducteur de plus de 5.10⁻⁶ K⁻¹ et dont l'épaisseur est inférieure ou égale à 0,3 mm. Afin d'éviter de casser les cellules de semi-conducteur, la face arrière est mise en forme, comme présenté en figure 3 et en figure 4.

On peut ainsi voir en figure 3 un module 20 avant mise sous vide, comprenant des cellules en silicium 22, une face avant en verre 23, une face arrière métallique 24, un joint périphérique en poly-butylène 25 et un joint en silicone 29. Les cellules 22 sont connectées entre elles par des rubans de cuivre 26. La face arrière 24 présente une série de zones mises en forme 24' qui entourent la périphérie de chaque cellule 22, structurant ainsi la face arrière 24. On peut également voir cette structuration sur la figure 1 qui représente un module 1 à face arrière 4 mise en forme, vu de dessus, présentant des zones mises en forme référencées 4' entre les cellules 2.

Après mise sous vide du module 20, on voit en figure 4 que les zones 24' se sont mises en place sous l'effet de la dépression, pour prendre la forme de boîtes sensiblement carrées englobant chaque cellule 22, à distance de celle-ci.

Cette mise en forme peut se faire par tout moyen technique adapté, tel que par exemple l'emboutissage. Les dimensions et l'emplacement exact des zones 4', 24' dépendent de la dépression qui règne dans le module 1, 20, mais aussi du coefficient de dilatation entre 0 et 100°C de la face arrière et de la face avant, des épaisseurs des faces arrière et avant, des caractéristiques mécaniques des faces arrière et avant (limite élastique) et de la taille des cellules de semi-conducteur. Les dimensions et l'emplacement des zones 4', 24' peuvent être facilement déterminés par l'homme du métier au cas par cas, notamment au moyen de logiciels courants de simulation de comportement des matériaux. Ils sont dans tous les cas calculés pour éviter tout contact entre la face arrière et les extrémités des cellules lors du fonctionnement du module, en particulier lors des cycles thermiques auquel il sera soumis.

Dans un troisième mode de réalisation, on préfère utiliser une face arrière de module fabriquée à partir d'une feuille présentant une épaisseur supérieure à 0,3 mm.

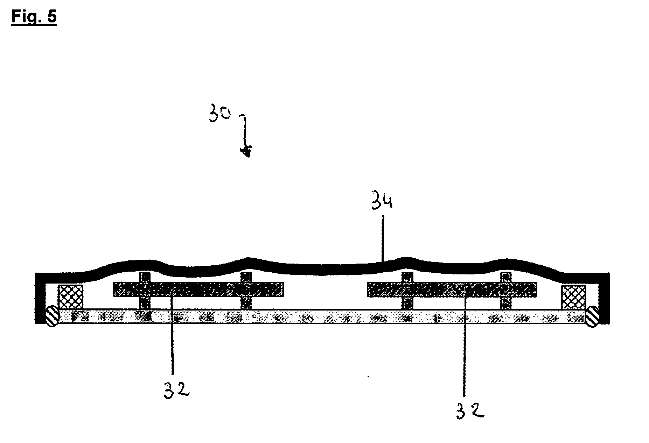

Comme on peut le voir schématiquement sur le module 30 en figure 5, la face arrière 34 se déforme encore mais ne nappe plus autant les cellules au silicium 32. Cette face arrière 34 présente cependant une face arrière rugueuse, du fait de la présence d'une couche de colle (non représentée). Lors de la mise en service du module 30, les cellules 32 vont donc être en contact avec la face arrière 34. Il convient donc de choisir pour cette face arrière un matériau dont le coefficient de dilatation entre 0 et 100°C est proche de celui du semi-conducteur, pour éviter une rupture en fatigue des cellules.

La dilatation du silicium étant généralement comprise entre 2,5.10⁻⁶ K⁻¹ et 4,5.10⁻⁶ K⁻¹, il est préférable que l'écart de dilatation entre la face arrière mince et les cellules photovoltaïques de silicium n'excède pas 4,5.10⁻⁶ K⁻¹. De ce fait, la dilatation des faces arrière minces pour une telle cellule au silicium doit être comprise entre 0 et 9.10⁻⁶ K⁻¹.

Exemple 3 - Tenue du module

On a réalisé une série de modules photovoltaïques comprenant une face avant en verre sodo-calcique d'une épaisseur de 3 mm et une face arrière métallique en différents matériaux, le module étant scellé par un joint organique périphérique et par un joint silicone. Les modules réalisés comprennent des cellules au silicium dont le coefficient de dilatation est d'environ 4,5.10⁻⁶ K⁻¹. Les faces arrières sont planes avant mise sous vide, à l'exception de leurs bords et ne comportent pas de revêtements modifiant le coefficient de dilatation de la face arrière.

Ces modules ont été soumis à un test d'évolution des cellules photovoltaïques en silicium, après une série de 500 cycles de 6 heures entre -45°C et +85°C.

Les résultats de ces essais sont rassemblés dans le tableau 4 :

Tableau 4

| Essai | Face arrière | Epaisseur (mm) | Composition (% poids) | $\alpha_{FA}$ (10⁻⁶ °K⁻¹) | $|\alpha_{FA} - \alpha_{SC}|$ | Etat des cellules Si |
|---|---|---|---|---|---|---|
| 1* | N426 | 0,4 | 42Ni-6Cr-Fe | 6,9 | 2,4 | Bon |
| 2* | Titane | 0,4 | Ti | 8,6 | 4,1 | Bon |
| 3* | N475 | 0,4 | 47Ni-7Cr-Fe | 8,7 | 4,2 | Bon |
| 4 | F17T | 0,4 | 17Cr-0,4Ti-Fe | 10,2 | 5,7 | Fissures |
| 5 | F18MT | 0,4 | 18Cr-2,1Mo-0,3Ti-Fe | 11,2 | 6,7 | Fissures |
| 6 | Inox 316L | 0,4 | 17,5Cr-12,5Ni-2,5Mo-Fe | 16 | 11,5 | Fissures |

(suite)

| Essai | Face arrière | Epaisseur (mm) | Composition (% poids) | $\alpha_{FA}$ ($10^{-6}$ °K$^{-1}$) | $\|\alpha_{FA} - \alpha_{SC}\|$ | Etat des cellules Si |
|---|---|---|---|---|---|---|
| 7 | Aluminium | 0,4 | Al > 90% | 23 | 18,5 | Fissures |
| *: selon l'invention | | | | | | |

On constate que seuls les modules dont le coefficient de dilatation a été choisi de façon adéquate par rapport au semi-conducteur présentent une tenue en fatigue satisfaisante.

Pour les modules dont les faces arrières présentent un coefficient de dilatation trop élevé, il est nécessaire de structurer ces faces arrières, comme cela a été décrit en détail pour les faces dont l'épaisseur est inférieure à 0,3 mm.

Les modules selon l'invention, que leurs faces arrières soient structurées ou non, permettent tous d'obtenir une bonne protection mécanique de l'arrière des cellules de semi-conducteur, ainsi qu'une excellente étanchéité à la vapeur d'eau.

## Revendications

1. Module (1, 10, 20, 30) de production de lumière ou d'énergie comprenant au moins un générateur de lumière ou d'énergie incluant au moins une cellule en semi-conducteur (2, 12, 22, 32) et disposé dans une enceinte étanche sous pression réduite, ladite enceinte comprenant une face avant (3, 13, 23) en verre, une face arrière (4, 14, 24, 34) en métal ou alliage métallique éventuellement revêtue sur l'une ou l'autre de ses faces, un joint de scellement périphérique (5, 15, 25), ainsi que des connecteurs électriques (6, 16, 26), ladite face arrière (4, 14, 24, 34) étant isolée électriquement desdits générateurs, **caractérisé en ce que** ladite face arrière (4, 14, 24, 34) présente une épaisseur de métal ou d'alliage métallique inférieure à 1 mm.

2. Module (1, 10) selon la revendication 1, **caractérisé en ce que** ladite face arrière (4, 14) présente une épaisseur de métal ou d'alliage métallique inférieure ou égale à 0,3 mm et **en ce que** la face arrière (4, 14) présente un coefficient de dilatation $\alpha_{FA}$ entre 0 et 100°C dont la différence en valeur absolue par rapport au coefficient de dilatation $\alpha_{SC}$ dudit semi-conducteur entre 0 et 100°C est telle que :

$$\left|\alpha_{FA} - \alpha_{SC}\right| \le 5.10^{-6} \text{ K}^{-1}$$

3. Module (20) selon la revendication 1, **caractérisé en ce que** ladite face arrière (24) présente un coefficient de dilatation $\alpha_{FA}$ entre 0 et 100°C dont la différence en valeur absolue par rapport au coefficient de dilatation $\alpha_{SC}$ dudit semi-conducteur entre 0 et 100°C est telle que :

$$\left|\alpha_{FA} - \alpha_{SC}\right| > 5.10^{-6} \text{K}^{-1}$$

ladite face arrière (24) présentant une épaisseur de métal ou d'alliage métallique inférieure ou égale à 0,3 mm et étant mise en forme dans les zones (24') situées entre lesdites cellules (22) en semi-conducteur, de telle sorte qu'elle ne vienne pas en contact avec les bords de ces cellules (22) lors du fonctionnement du module (20).

4. Module (30) selon la revendication 1, **caractérisé en ce que** ladite face arrière (34) présente une épaisseur de métal ou d'alliage métallique supérieure à 0,3 mm et **en ce que** la face arrière (34) présente un coefficient de dilatation $\alpha_{FA}$ entre 0 et 100°C, dont la différence en valeur absolue par rapport au coefficient de dilatation $\alpha_{SC}$ du semi-conducteur est telle que :

$$\left|\alpha_{FA} - \alpha_{SC}\right| \le 4,5.10^{-6} \text{ K}^{-1}$$

**5.** Module (1, 10, 20, 30) selon l'une quelconque des revendications 1 à 4, **caractérisé en ce que** ladite face arrière (4, 14, 24, 34) est isolée des dites cellules (2, 12, 22, 32) à l'aide d'un revêtement isolant choisi parmi les polymères non-conducteurs.

**6.** Module (1, 10, 20, 30) selon la revendication 5, **caractérisé en ce que** ledit revêtement comprend des composés isolants électriques et conducteurs thermiques, susceptibles d'extraire la chaleur dudit module (1, 10, 20, 30), tels que des poudres de nitrures d'aluminium.

**7.** Module (1, 10, 20, 30) selon l'une quelconque des revendications 1 à 6, **caractérisé en ce qu'**il s'agit d'un module photovoltaïque.

**8.** Module photovoltaïque (1, 10) selon la revendication 7, **caractérisé en ce que** ledit semi-conducteur est le silicium, ladite face arrière (4, 14) présente une épaisseur inférieure ou égale à 0,3 mm et est constituée d'alliage fer-Nickel comprenant 34 à 42% de nickel, avec ou sans revêtement de protection contre la corrosion.

**9.** Module photovoltaïque (20) selon la revendication 7, **caractérisé en ce que** ledit semi-conducteur est le silicium, ladite face arrière (24) présente une épaisseur inférieure ou égale à 0,3 mm, est constituée d'acier inoxydable de type F18MT et est mise en forme dans les zones (24') entre les cellules de semi-conducteur (22), de telle sorte que la face arrière (24) n'entre pas en contact avec les bords de ces cellules (22).

**10.** Module photovoltaïque selon la revendication 7, **caractérisé en ce que** ladite face arrière présente une épaisseur supérieure à 0,3 mm, est constituée d'alliage fer-Nickel de type N485 ou d'acier inoxydable de type F18MT et est mise en forme dans les zones entre les cellules de semi-conducteur, de telle sorte que la face arrière n'entre pas en contact avec les bords de ces cellules.

**11.** Module photovoltaïque selon la revendication 7, **caractérisé en ce que** ladite face arrière présente une épaisseur supérieure à 0,3 mm, est constituée d'acier au carbone galvanisé et est mise en forme dans les zones entre les cellules de semi-conducteur, de telle sorte que la face arrière n'entre pas en contact avec les bords de ces cellules.

**12.** Module selon l'une quelconque des revendications 1 à 6, **caractérisé en ce qu'**il s'agit d'un écran de visualisation.

**13.** Module selon l'une quelconque des revendications 1 à 6, **caractérisé en ce qu'**il s'agit d'un module d'éclairage LED ou OLED.

**Fig. 1**

**Fig. 2**

**Fig. 3**

**Fig. 4**

**<u>Fig. 5</u>**

30

34

32

32

**Office européen des brevets**

**RAPPORT DE RECHERCHE EUROPEENNE**

Numéro de la demande

EP 07 29 0184

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X<br>Y | US 4 231 807 A (KEELING MICHAEL C ET AL) 4 novembre 1980 (1980-11-04)<br>* colonne 2, ligne 6-36; figures 1-4 *<br><br>* colonne 2, ligne 61 - colonne 4, ligne 64 *<br>----- | 1,5-7,9, 11<br>2-4,8, 10,12,13 | INV.<br>H01L31/048 |
| Y | US 2003/201007 A1 (FRAAS LEWIS M [US] ET AL) 30 octobre 2003 (2003-10-30)<br>* alinéas [0052] - [0088]; figures 1,2,6,14 *<br>----- | 2-4,8,10 | |
| Y | US 2005/212419 A1 (VAZAN FRIDRICH [US] ET AL) 29 septembre 2005 (2005-09-29)<br>* abrégé *<br>* figures 7a-11a *<br>----- | 12,13 | |
| A | US 2003/209772 A1 (PRABHU ASHOK [US]) 13 novembre 2003 (2003-11-13)<br>* le document en entier *<br>----- | 1-13 | |
| A | US 2004/112424 A1 (ARAKI KENJI [JP] ET AL) 17 juin 2004 (2004-06-17)<br>* le document en entier *<br>----- | 1-13 | DOMAINES TECHNIQUES RECHERCHES (IPC)<br><br>H01L |
| A | EP 0 436 912 A (HUGHES AIRCRAFT CO [US]) 17 juillet 1991 (1991-07-17)<br>* le document en entier *<br>----- | 1-13 | |
| A | US 4 461 922 A (GAY CHARLES F [US] ET AL) 24 juillet 1984 (1984-07-24)<br>* le document en entier *<br>----- | 1-13 | |

Le présent rapport a été établi pour toutes les revendications

| Lieu de la recherche | Date d'achèvement de la recherche | Examinateur |
|---|---|---|
| La Haye | 5 juillet 2007 | Boero, Mauro |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 07 29 0184

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

05-07-2007

| Document brevet cité au rapport de recherche | | | Date de publication | Membre(s) de la famille de brevet(s) | | | Date de publication |
|---|---|---|---|---|---|---|---|
| US 4231807 | A | | 04-11-1980 | AUCUN | | | |
| US 2003201007 | A1 | | 30-10-2003 | CN | 1461059 | A | 10-12-2003 |
| US 2005212419 | A1 | | 29-09-2005 | WO | 2005101542 | A1 | 27-10-2005 |
| US 2003209772 | A1 | | 13-11-2003 | AUCUN | | | |
| US 2004112424 | A1 | | 17-06-2004 | AUCUN | | | |
| EP 0436912 | A | | 17-07-1991 | AU | 629438 | B2 | 01-10-1992 |
| | | | | AU | 6819990 | A | 11-07-1991 |
| | | | | CA | 2032266 | A1 | 06-04-1993 |
| | | | | IL | 96673 | A | 15-03-1993 |
| | | | | JP | 4211137 | A | 03-08-1992 |
| | | | | NO | 910101 | A | 11-07-1991 |
| | | | | US | 5027189 | A | 25-06-1991 |
| US 4461922 | A | | 24-07-1984 | AUCUN | | | |

EPO FORM P0460

Pour tout renseignement concernant cette annexe : voir Journal Officiel de l'Office européen des brevets, No.12/82

**EP 1 959 502 A1**

## RÉFÉRENCES CITÉES DANS LA DESCRIPTION

### Documents brevets cités dans la description

- WO 2004095586 A